# EUROPÄISCHE PATENTSCHRIFT

(11) **EP 2 849 310 B1**
(45) Veröffentlichungstag und Bekanntmachung des Hinweises auf die Patenterteilung: **06.07.2022**
(21) Anmeldenummer: 14179844.7
(22) Anmeldetag: 05.08.2014
(51) Int. Cl.: H05K 7/14, H05K 5/06, H02J 7/00, H05K 7/20

(54) **Akkuladevorrichtung**
Battery charging device
Chargeur de batterie

(30) Priorität: 16.09.2013 DE 102013218534
(43) Veröffentlichungstag der Anmeldung: 18.03.2015
(73) Patentinhaber: Robert Bosch GmbH, 70442 Stuttgart (DE)
(72) Erfinder: Osswald, Alexander, 70599 Stuttgart (DE); Seidel, Thorsten, 71686 Remseck (DE)

(56) Entgegenhaltungen:
- EP-A2- 1 422 983
- WO-A1-2012/147189
- DE-A1-102007 042 398
- US-A1- 2003 117 107
- US-A1- 2011 192 568
- US-A1- 2012 025 766
- US-B1- 6 396 239

## Beschreibung

### Stand der Technik

Es sind bereits Akkuladevorrichtungen vorgeschlagen worden, bei denen ein Akku zu einer Aufladung in einen Akkuladeraum eingebracht wird, in dem eine Leistungselektronikeinheit angeordnet ist, z.B. in den Dokumenten DE 10 2007 042398 A1, US 2012/025766 A1, US 2003/117107 A1 und US 6 396 239 B1. Weiter, Dokumente EP 1 422 983 A2, WO 2012/147189 A1 und US 2011/192568 A1 sind Beispiele von Leistungseletronikgehäusen mit hermetischen und wärmeleitenden Eigenschaften.

### Offenbarung der Erfindung

Die Erfindung geht aus von einer Akkuladevorrichtung mit einem Akkuaufnahmegehäuse, das zumindest einen Akkuaufnahmeraum zumindest teilweise begrenzt, und mit zumindest einer Leistungselektronikeinheit, die zumindest dazu vorgesehen ist, eine Ladespannung bereitzustellen.

Es wird vorgeschlagen, dass die Akkuladevorrichtung ein von dem Akkuaufnahmegehäuse getrennt hergestelltes Elektronikgehäuse aufweist, das dazu vorgesehen ist, die Leistungselektronikeinheit zumindest wassergeschützt und/oder staubgeschützt aufzunehmen.

Unter einer "Akkuladevorrichtung" soll insbesondere eine Vorrichtung verstanden werden, die dazu vorgesehen ist, einen zumindest teilweise entladenen Akku aufzuladen und hierzu elektrische Energie in Form von Strom aus einer Stromleitung oder von einer Stromquelle zu entnehmen und auf den Akku zu übertragen. Insbesondere umfasst die Akkuladevorrichtung zumindest eine Stromwandlungseinheit, die dazu vorgesehen ist, entnommenen Strom auf eine Ladespannung zu transformieren. Unter "vorgesehen" soll insbesondere speziell programmiert, ausgelegt und/oder ausgestattet verstanden werden. Darunter, dass ein Objekt zu einer bestimmten Funktion vorgesehen ist, soll insbesondere verstanden werden, dass das Objekt diese bestimmte Funktion in zumindest einem Anwendungs- und/oder Betriebszustand erfüllt und/oder ausführt. Unter einem "Akku" soll insbesondere eine wiederaufladbare Energiespeichervorrichtung verstanden werden, die elektrische Energie in einem Speichermedium mittels einer reversiblen chemischen Reaktion speichert. Grundsätzlich kann der Akku mehrere Akkuzellen aufweisen, welche in Reihe zueinander geschaltet sind, wobei sich eine Akkuspannung aus einer Summe von Spannungen der mehreren Akkuzellen zusammensetzt. Unter einem "Akkuaufnahmegehäuse" soll insbesondere ein Gehäuse verstanden werden, welches zumindest einen Akkuaufnahmeraum zumindest teilweise begrenzt. Insbesondere kann das Akkuaufnahmegehäuse zusätzlich zu dem zumindest einen Akkuaufnahmeraum zumindest einen weiteren Raum zumindest teilweise begrenzen, wobei ein Wandungselement des Akkuaufnahmegehäuses den zumindest einen weiteren Raum zumindest teilweise gegenüber dem zumindest einen Akkuaufnahmeraum zumindest teilweise begrenzt. Unter "zumindest teilweise begrenzen" soll insbesondere verstanden werden, dass ein Gehäuse zumindest Öffnungen aufweist, durch die Elemente zu einer Verbindung mit einem Element, das in dem von dem Gehäuse zumindest teilweise begrenzten Raum aufgenommen ist, wie beispielsweise Stromversorgungselemente oder Wärmeabfuhrelemente, hindurchgeführt sind und/oder durch die ein Element, welches in dem von dem Gehäuse zumindest teilweise begrenzten Raum aufgenommen werden soll, in den von dem Gehäuse zumindest teilweise begrenzten Raum eingeführt wird. Unter einem "Akkuaufnahmeraum" soll insbesondere ein Raum verstanden werden, der dazu vorgesehen ist, einen Akku aufzunehmen, wobei in dem Akkuaufnahmeraum zumindest eine Akkuschnittstelle angeordnet ist, die dazu vorgesehen ist, elektrische Energie auf den aufzuladenden Akku zu übertragen. Insbesondere wird ein aufzuladender Akku aufgeladen, wenn er in die Ackuschnittstelle in einer dazu vorgesehenen Orientierung eingesetzt wird. Unter einem "Aufnehmen eines Elements in einen Raum" soll insbesondere verstanden werden, dass das Element in einem aufgenommenen Zustand zumindest zu fünfzig Prozent eines Gesamtvolumens in den Raum eingebracht ist. Unter einer "Leistungselektronikeinheit" soll insbesondere eine Einheit verstanden werden, welche die zumindest eine Stromwandlungseinheit und elektronische Einheiten zu einer Sensierung eines Ladezustands des eingesetzten Akkus sowie zu einer Steuerung eines Aufladeprozesses umfasst. Unter einer "Ladespannung" soll insbesondere eine Spannung verstanden werden, mit welcher der Akku aufgeladen wird. Insbesondere ist die Ladespannung identisch mit einer Akkuspannung, mit der der Akku Strom abgibt. Unter einem "Elektronikgehäuse" soll insbesondere ein Gehäuse verstanden werden, welches einen Elektronikaufnahmeraum zumindest teilweise begrenzt. Vorzugsweise ist das Elektronikgehäuse als quaderförmiges Gehäuse ausgebildet. Unter einem "Elektronikaufnahmeraum" soll insbesondere ein Raum verstanden werden, in dem die eine Leistungselektronikeinheit zumindest teilweise, vorzugsweise vollständig, aufgenommen ist. Insbesondere ist zumindest ein Stromleitungselement durch das Elektronikgehäuse durchgeführt, welche dazu vorgesehen ist, die zumindest eine Stromwandlungseinheit und einen aufzuladenden Akku zu verbinden. Vorzugsweise verbindet das zumindest eine Stromleitungselement die zumindest eine Stromwandlungseinheit und die Akkuschnittstelle. Unter "wassergeschützt und/oder staubgeschützt" soll insbesondere verstanden werden, dass das Elektronikgehäuse in zumindest einem Betriebszustand ein Eindringen von Wasser und/oder Staub in den Elektronikaufnahmeraum vermeidet. Insbesondere erfüllt das Elektronikgehäuse Sicherheitsanforderungen entsprechend einer Schutzart nach dem sogenannten IP-Code gemäß der DIN EN 60529 von IP34, vorteilhaft zumindest von IP35, bevorzugt zumindest von IP55 und besonders bevorzugt zumindest von IP67. Unter einem "von dem Akkuaufnahmegehäuse getrennt ausgebildeten Elektronikgehäuse" soll insbesondere ein Elektronikgehäuse, das getrennt von dem Akkuaufnahmegehäuse hergestellt worden ist und dazu vorgesehen ist, an dem Akkuaufnahmegehäuse formschlüssig und/oder kraftschlüssig montiert zu werden, verstanden werden, wobei nach einer Montage des Elektronikgehäuses an dem Akkuaufnahmegehäuse der von dem Elektronikgehäuse zumindest teilweise begrenzte Elektronikaufnahmeraum durch das Elektronikgehäuse zumindest teilweise von dem Akkuaufnahmeraum getrennt ist.

Durch die erfindungsgemäße Ausgestaltung der Akkuladevorrichtung kann insbesondere eine sichere und wassergeschützte Aufladung eines Akkus erreicht werden. Insbesondere kann die erfindungsgemäße Akkuladevorrichtung außerhalb eines geschlossenen Raums auch unter ungünstigen Bedingungen wie beispielsweise Regen sicher verwendet werden.

In einer Weiterbildung der Erfindung wird vorgeschlagen, dass das zumindest eine Elektronikgehäuse zumindest einen Deckkörper und einen Hauptkörper aufweist. Unter einem "Deckkörper" soll insbesondere ein vorzugsweise plattenförmiger Körper verstanden werden, welcher einen Raum auf zumindest einer Seite zumindest teilweise begrenzt. Unter einem "Hauptkörper" soll insbesondere ein Körper verstanden werden, der den Raum auf zumindest zwei Seiten und bevorzugt von allen Seiten bis auf eine durch den Deckkörper zumindest teilweise begrenzte Seite zumindest teilweise begrenzt. Es kann insbesondere ein einfach konstruiertes und unaufwendig herstellbares Elektronikgehäuse erreicht werden.

Weiterhin wird vorgeschlagen, dass das zumindest eine Elektronikgehäuse zumindest eine Dichtungseinheit aufweist, die den zumindest einen Deckkörper und den Hauptkörper thermisch zumindest teilweise entkoppelt. Unter "thermisch zumindest teilweise entkoppelt" soll insbesondere verstanden werden, dass die zumindest eine Dichtungseinheit eine Wärmetransportvolumenleistungsdichte aufweist, die maximal halb so groß, vorteilhaft maximal ein Fünftel so groß und bevorzugt maximal ein Zehntel so groß ist wie eine Wärmetransportvolumenleistungsdichte von dem Deckkörper und dem Hauptkörper des Elektronikgehäuses, so dass eine Erwärmung des Deckkörpers oder des Hauptkörpers sich nur mit einer großen zeitlichen Verzögerung auf den Hauptkörper oder den Deckkörper überträgt. Insbesondere kann eine Kühlung auf einen Teilkörper des Elektronikgehäuses konzentriert werden, bei dem eine größte Wärmemenge anfällt. Insbesondere beträgt in zumindest einem Betriebszustand, bei dem die Akkuladevorrichtung mit einer vollen Leistung betrieben wird, ein Temperaturunterschied zwischen dem zumindest einen Deckkörper und dem Hauptkörper etwa 10 Grad. Insbesondere ist die Akkuladevorrichtung dazu vorgesehen, in der Leistungselektronik anfallende Abwärme entweder an den Deckkörper oder an den Hauptkörper zu leiten, so dass eine Kühlung zu einer Vermeidung einer Überhitzung der Leistungselektronik entweder auf den Deckkörper oder den Hauptkörper konzentriert werden kann. Es kann insbesondere ein einfaches Wärmemanagement erreicht werden.

Des Weiteren wird vorgeschlagen, dass die Akkuladevorrichtung zumindest ein Wärmetransportelement aufweist, das den zumindest einen Deckkörper thermisch mit der Leistungselektronikeinheit verbindet. Unter einem "Wärmetransportelement" soll insbesondere ein Element verstanden werden, das dazu vorgesehen ist, Wärme mittels Wärmeleitung, Wärmestrahlung oder Konvektion zwischen zwei Orten zu transportieren und das eine Wärmetransportleistung aufweist, welche zumindest doppelt so groß, vorteilhaft zumindest viermal so groß und bevorzugt zumindest zehnmal so groß ist wie eine Wärmetransportleistung von Elementen, die das Wärmetransportelement umgeben. Insbesondere ist das Wärmetransportelement als ein Wärmetransportelement ausgebildet, das eine Wärmeleitfähigkeit aufweist, welche zumindest doppelt so groß, vorteilhaft zumindest viermal so groß und bevorzugt zumindest zehnmal so groß ist wie eine Wärmeleitfähigkeit von Elementen, welche das Wärmetransportelement umgeben, insbesondere wie eine Wärmeleitfähigkeit des Hauptkörpers. Insbesondere kann das zumindest eine Wärmetransportelement aus einem Metall hergestellt sein. Bevorzugt ist das zumindest eine Wärmetransportelement als ein metallener Kühlkörper, beispielsweise aus Aluminium, ausgebildet. Alternativ kann beispielsweise ein Wärmerohr verwendet werden. Es kann insbesondere eine Wärmeabfuhr für die Leistungselektronikeinheit mit einer hohen Wärmetransportleistung bei gleichzeitiger Vermeidung einer hohen Erwärmung von an die Leistungselektronik angrenzenden Bauteilen bewirkt werden.

Ferner wird vorgeschlagen, dass der zumindest eine Deckkörper Kühlrippen aufweist. Darunter, dass "der Deckkörper Kühlrippen aufweist", soll insbesondere verstanden werden, dass zumindest eine Körperoberfläche des Deckkörpers Erhebungen aufweist, mittels denen eine Oberfläche gegenüber einer glatt ausgeführten Körperoberfläche vergrößert wird, um eine höhere Wärmeabstrahlung und somit eine höhere Abkühlung des Deckkörpers zu erreichen. Es kann insbesondere eine hohe Wärmeabstrahlung des Deckkörpers erreicht und eine große Erhitzung des Deckkörpers durch Abwärme vermieden werden.

Des Weiteren wird vorgeschlagen, dass die Akkuladevorrichtung zumindest einen Lüfter aufweist, der dazu vorgesehen, einen Luftstrom zur Kühlung des Elektronikgehäuses zu erzeugen. Unter einem "Lüfter" soll insbesondere eine Einheit mit zumindest einem einen Luftstrom erzeugenden Ventilator verstanden werden. Darunter, dass "der zumindest einen Luftstrom zur Kühlung des Elektronikgehäuses vorgesehen ist", soll insbesondere verstanden werden, dass der Luftstrom auf das Elektronikgehäuse gerichtet ist. Vorteilhaft ist der Luftstrom auf den Deckkörper gerichtet. Alternativ oder zusätzlich kann die Akkuladevorrichtung eine Kühleinheit mit einem alternativen Kühlverfahren, beispielsweise einen Wasserkühler, umfassen. Es kann insbesondere eine technisch einfache, robuste Kühlung erreicht werden.

Weiterhin wird vorgeschlagen, dass der zumindest eine Lüfter zwischen dem Deckkörper und dem Akkuaufnahmeraum angeordnet ist. Insbesondere ist der zumindest eine Lüfter in einem weiteren Raum, der von dem Akkuaufnahmegehäuse zumindest teilweise begrenzt ist und der zumindest teilweise von dem Akkuaufnahmeraum durch ein Wandungselement des Akkuaufnahmegehäuses getrennt ist, angeordnet. Alternativ kann der Lüfter in dem Akkuaufnahmeraum angeordnet sein. Alternativ kann der Lüfter in dem Elektronikaufnahmeraum in Richtung auf den Akkuaufnahmeraum gesehen vor der Leistungselektronikeinheit angeordnet sein. Alternativ kann der Lüfter in einem Bereich angeordnet sein, der von dem Akkuaufnahmeraum aus gesehen hinter der Leistungselektronikeinheit, entweder in dem Elektronikaufnahmeraum oder in einem separaten Raum, angeordnet ist. Ist der Lüfter in dem Elektronikaufnahmeraum innerhalb des wasser- und staubdichten Elektronikgehäuses angeordnet, so wälzt er Luft innerhalb des Elektronikgehäuses zu einer Erzielung einer Kühlwirkung um. Es kann insbesondere eine vorteilhafte Luftführung erreicht werden.

Ferner wird vorgeschlagen, dass die Akkuladevorrichtung zumindest ein Luftführungsmittel umfasst, das Luft an einem in den zumindest einen Akkuaufnahmeraum eingesetzten Akku vorbei führt. Bevorzugt ist das Luftführungsmittel als ein Kanal in dem Akkuaufnahmegehäuse ausgebildet, alternativ ist beispielsweise ein als Röhre ausgebildetes Luftführungsmittel vorstellbar. Es kann insbesondere eine vorteilhafte Luftführung erreicht werden.

Weiterhin wird vorgeschlagen, dass die Akkuladevorrichtung zumindest ein Verriegelungsmittel aufweist, das dazu vorgesehen ist, zumindest in einem Ladezustand einen in einen Akkuaufnahmeraum eingesetzten Akku zu verriegeln. Unter einem "Ladezustand" soll insbesondere ein Betriebszustand der Akkuladevorrichtung verstanden werden, in dem ein Akku aufgeladen wird. Unter einem "Verriegelungsmittel" soll insbesondere ein Mittel verstanden werden, dass in zumindest einem Betriebszustand in einem formschlüssigen Eingriff mit dem Akku steht und durch diesen formschlüssigen Eingriff eine Bewegung des Akkus aus dem Akkuaufnahmeraum verhindert. Es kann insbesondere eine Sicherung des aufzuladenden Akkus gegen ein unbeabsichtigtes Herausfallen erreicht werden.

Ferner wird vorgeschlagen, dass die Akkuladevorrichtung zumindest eine Akkuschnittstelle zu einer elektrischen Kontaktierung eines Akkus umfasst, die zumindest ein blank ausgeführtes Kontaktelement aufweist. Unter einer "Akkuschnittstelle" soll insbesondere eine Einheit mit zumindest einem Kontaktbereich für einen Akku mit zumindest einem Kontaktelement verstanden werden, welches ein korrespondierendes Kontaktelement des Akkus kontaktiert und mit dem korrespondierenden Kontaktelement des Akkus eine elektrisch leitende Verbindung ausbildet, über die der elektrische Strom zur Aufladung des Akkus fließt. Unter einem "blank ausgeführten Kontaktelement" soll insbesondere ein Kontaktelement verstanden werden, welches zumindest im Wesentlichen freiliegend innerhalb eines Raums angeordnet ist und im Wesentlichen frei von einer Schutzumhüllung und/oder einer Schutzbeschichtung gegenüber einem Kurzschluss ist. Unter "zumindest im Wesentlichen frei von einer Schutzumhüllung und/oder einer Schutzbeschichtung" soll insbesondere verstanden werden, dass maximal sechzehn Quadratmillimeter, vorteilhaft maximal acht Quadratmillimeter und bevorzugt maximal vier Quadratmillimeter einer Oberfläche des Kontaktelements von einer Schutzumhüllung und/oder einer Schutzbeschichtung bedeckt sind. Insbesondere ist ein blank ausgeführtes Kontaktelement verschieden von einem Kontaktelement, welches aus einem Stecker hervortritt und zu einer Einführung in eine Steckverbindung vorgesehen ist. Es kann insbesondere eine hohe Energieübertragungsleistung erreicht werden.

Des Weiteren wird vorgeschlagen, dass die zumindest eine Akkuschnittstelle Wasserablauföffnungen aufweist. Unter "Wasserablauföffnungen" sollen insbesondere in dem Kontaktbereich angeordnete Öffnungen verstanden werden, durch welche Wasser, welches in den Akkuaufnahmeraum eindringt, ablaufen kann. Es kann insbesondere eine Akkuladevorrichtung mit einer hohen Betriebssicherheit erreicht werden.

Weiterhin wird vorgeschlagen, dass das Akkuaufnahmegehäuse zumindest teilweise, vorzugsweise vollständig, aus einem Kunststoffmaterial und das Elektronikgehäuse zumindest teilweise, vorzugsweise vollständig, aus einem Metall hergestellt ist. Unter "zumindest teilweise aus einem Stoff hergestellt" soll insbesondere verstanden werden, dass zumindest siebzig Prozent, vorteilhaft zumindest achtzig Prozent, bevorzugt zumindest neunzig Prozent und besonders bevorzugt hundert Prozent eines Massenanteils eines Materials aus dem Stoff bestehen. Unter einem "Kunststoffmaterial" soll insbesondere ein Reinmaterial oder eine Materialmischung von Materialien aus der Materialgruppe der Kunststoffe, wie beispielsweise Polyethylen oder Polypropylen, verstanden werden. Unter einem "Metall" soll insbesondere ein Reinmetall oder eine Legierung verstanden werden. Bevorzugt ist das Elektronikgehäuse aus Aluminium hergestellt. Es kann insbesondere eine gezielte Abstimmung von Eigenschaften des Akkuaufnahmegehäuses und des Elektronikgehäuses auf unterschiedliche Anforderungen erreicht werden.

Ferner wird vorgeschlagen, dass die Akkuladevorrichtung einen Handgriff umfasst, der auf einer Seite mit dem Akkuaufnahmegehäuse und auf einer entgegengesetzten Seite mit dem Elektronikgehäuse verbunden ist. Bevorzugt ist der Handgriff als zumindest teilweise elastisches Bauteil ausgebildet, grundsätzlich kann der Handgriff jedoch als ein starres Bauteil ausgebildet sein.

Zudem wird ein System aus einer erfindungsgemäßen Akkuladevorrichtung und einem zumindest teilweise wasserdicht ausgebildeten Akku vorgeschlagen. Unter einem "zumindest teilweise wasserdicht ausgebildeten Akku" soll insbesondere ein Akku verstanden werden, der nach einem vollständigen Untertauchen im Wasser und anschließender oberflächlicher Abtrocknung verwendet werden kann und bei Verwendung eine Leistung liefert, welches maximal fünf Prozent geringer ist als eine gelieferte Leistung vor dem Untertauchen. Es kann insbesondere eine Akkuladung mit einer hohen Betriebssicherheit erreicht werden.

Die erfindungsgemäße Akkuladevorrichtung soll hierbei nicht auf die oben beschriebene Anwendung und Ausführungsform beschränkt sein. Insbesondere kann die erfindungsgemäße Akkuladevorrichtung zu einer Erfüllung einer hierin beschriebenen Funktionsweise eine von einer hierin genannten Anzahl von einzelnen Elementen, Bauteilen und Einheiten abweichende Anzahl aufweisen.

### Zeichnung

Weitere Vorteile ergeben sich aus der folgenden Zeichnungsbeschreibung. In der Zeichnung ist ein Ausführungsbeispiel der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: eine erfindungsgemäße Akkuladevorrichtung in einer Gesamtansicht,
- Fig. 2: die erfindungsgemäße Akkuladevorrichtung in einer Darstellung mit einem freigelegten Akkuaufnahmeraum,
- Fig. 3: eine weitere Ansicht der erfindungsgemäßen Akkuladevorrichtung mit einem freigelegten Akkuaufnahmeraum,
- Fig. 4: die erfindungsgemäße Akkuladevorrichtung in einer Schnittdarstellung in Draufsicht,
- Fig. 5: eine Detaildarstellung der Leistungselektronikeinheit der erfindungsgemäßen Akkuladevorrichtung und
- Fig. 6: eine Schnittdarstellung der erfindungsgemäßen Akkuladevorrichtung.

### Beschreibung des Ausführungsbeispiels

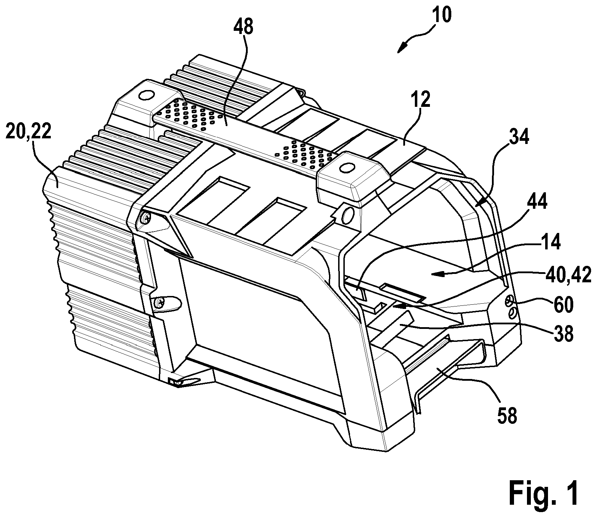

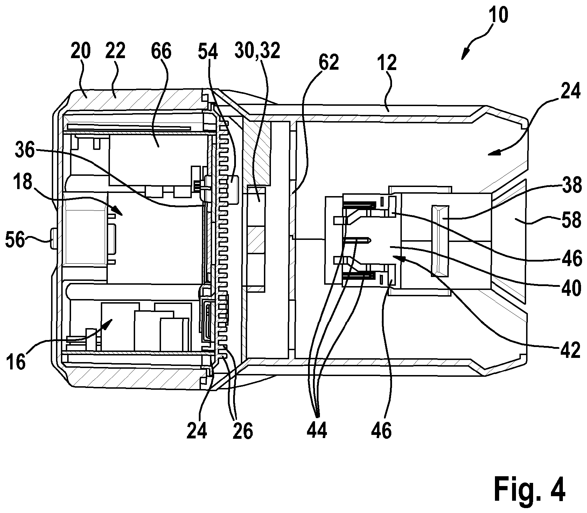

Fig. 1 zeigt eine erfindungsgemäße Akkuladevorrichtung 10 mit einem Akkuaufnahmegehäuse 12, das einen Akkuaufnahmeraum 14 teilweise begrenzt, mit einer Leistungselektronikeinheit 16 (in Fig. 1 verdeckt, siehe Fig. 4) und mit einem von dem Akkuaufnahmegehäuse 12 getrennt ausgebildetem Elektronikgehäuse 20. Die Leistungselektronikeinheit 16 ist dazu vorgesehen ist, eine Ladespannung zu einer Aufladung eines Akkus bereitzustellen. Das Elektronikgehäuse 20 nimmt die Leistungselektronikeinheit 16 wassergeschützt und staubgeschützt auf. Die Akkuladevorrichtung weist eine quaderförmige Grundgestalt mit einer Länge von siebenundzwanzig Zentimetern, wobei das Akkuaufnahmegehäuse 12 und das Elektronikgehäuse 20 entlang der Länge hintereinander angeordnet sind, und mit einer maximalen Breite von siebzehn Zentimetern auf. Vier Füße 50 zur Aufstellung der Akkuladevorrichtung 10 auf einen Boden sind auf einer Unterseite des Akkuaufnahmegehäuses 12 und des Elektronikgehäuses 20 angebracht.

Das Elektronikgehäuse 20 erfüllt Sicherheitsanforderungen entsprechend einer Schutzart nach dem sogenannten IP-Code gemäß der DIN EN 60529 von IP67, so dass das Elektronikgehäuse 20 staubdicht ist und einen Inhalt gegen zeitweiliges Untertauchen schützt. Das Elektronikgehäuse 20 begrenzt einen Elektronikaufnahmeraum 18 (Fig. 4), in den die Leistungselektronikeinheit 16 eingebracht ist. Das Akkuaufnahmegehäuse 12 ist aus einem Kunststoffmaterial und das Elektronikgehäuse 20 ist aus einem Metall hergestellt.

Die Akkuladevorrichtung 10 ist für eine Aufladung von Akkus für Elektrogeräte, wie beispielsweise Rasenmäher, Handkreissägen, Bohrhämmer oder dergleichen, mit einer Ladespannung von 36 V vorgesehen. Die Leistungselektronikeinheit 16 umfasst eine Stromwandlungseinheit, die Strom aus einem Stromnetz auf die Ladespannung transformiert, und elektronische Einheiten zu einer Sensierung eines Ladezustands eines in den Akkuaufnahmeraum 14 eingesetzten Akkus. Der Strom aus dem Stromnetz wird über ein Kabel bezogen, das über eine wasserdichten Gewindeverschraubung 56, die von einer sogenannten PG-Verschraubung gebildet ist, in einen Innenbereich der Akkuladevorrichtung 10 geführt wird. Die elektronischen Einheiten zu einer Sensierung eines Ladezustands des eingesetzten Akkus sind mit einem Anzeigeelement 60, das neben einer Öffnung des Akkuaufnahmeraums 14 angeordnet ist, verbunden. Das Anzeigeelement 60 ist als optisches Anzeigeelement 60 ausgebildet und weist zwei LED-Leuchtelemente auf, die den Ladezustand des Akkus sowie einen Lademodus anzeigen.

Die Akkuladevorrichtung 10 ist insbesondere dazu vorgesehen, die Akkus unmittelbar nach einem Betrieb in einem erwärmten Zustand schnell aufzuladen und umfasst dazu eine Kühleinheit 30. Die Leistungselektronikeinheit 16 der Akkuladevorrichtung 10 ist so dimensioniert, dass eine vollständige Aufladung eines Akkus mit einer Ladung von vier Amperestunden innerhalb einer halben Stunde abgeschlossen wird.

Alternativ kann die Akkuladevorrichtung 10 zu einer Ausführung zweier unterschiedlicher Ladungsmodi vorgesehen sein, einem normalen Lademodus, in dem der Akku über mehrere Stunden geladen wird und einem Schnelllademodus, in dem der Akku innerhalb einer Zeitdauer zwischen zwanzig Minuten und einer halben Stunde vollständig geladen wird. In dem Schnelllademodus fällt durch dabei auftretende elektrische Leistungen, welche deutlich höher sind als in dem normalen Lademodus auftretende elektrische Leistungen, eine sehr hohe Verlustleistung und somit eine sehr hohe Abwärme in der Leistungselektronikeinheit 16 an.

Die Akkuladevorrichtung 10 umfasst einen Handgriff 48, der auf einer Seite mit dem Akkuaufnahmegehäuse 12 und auf einer entgegengesetzten Seite mit dem Elektronikgehäuse 20 verbunden ist. Der Handgriff 48 ist als ein flexibler Handgriff 48 aus einem Metallblech mit einer Gummiumhüllung ausgebildet.

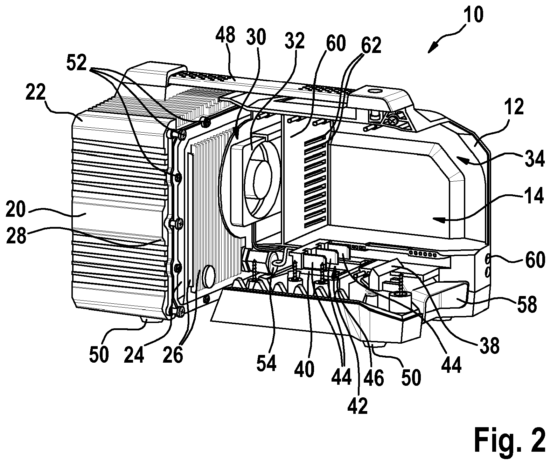

Das eine Elektronikgehäuse 20 weist einen Deckkörper 24 und einen Hauptkörper 22 auf (Fig. 2). Der Hauptkörper 22 begrenzt einen Elektronikaufnahmeraum 18 (Fig. 4), in dem die Leistungselektronikeinheit 16 eingesetzt ist, von fünf Seiten. Durch den Decckörper 24 und den Hauptkörper 22 wird der Elektronikaufnahmeraum 18 vollständig umschlossen. Deckkörper 24 und Hauptkörper 22 sind durch Schrauben 52 aneinander befestigt. Der Hauptkörper 22 bildet einen äußeren, durch einen Benutzer berührbaren Teil der Akkuladevorrichtung 10. Der Deckkörper 24 weist Kühlrippen 26 auf, die als Erhebungen über eine gedachte glatte Grundfläche abstehen und die eine Oberfläche des Deckkörpers 24 vergrößern. Somit wird auch eine wärmeabgebende Oberfläche im Vergleich zu einer glatten Ausführung vergrößert.

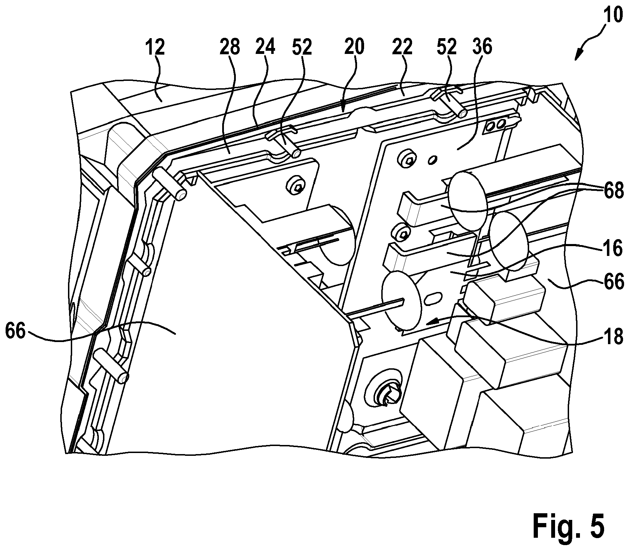

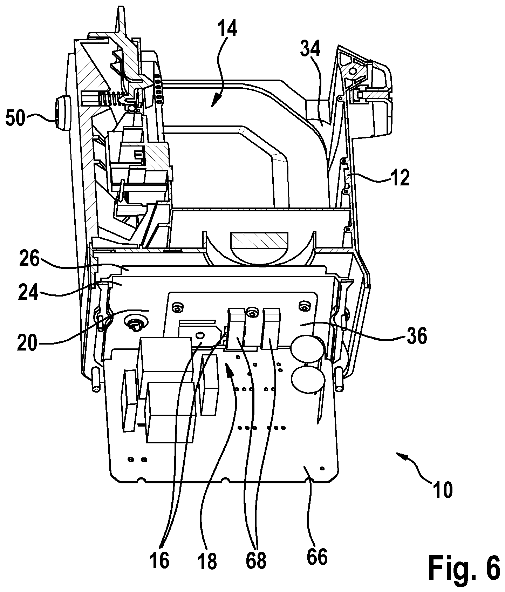

Das Elektronikgehäuse 20 weist eine Dichtungseinheit 28 auf, die den Deckkörper 24 und den Hauptkörper 22 thermisch teilweise entkoppelt. Leistungselemente der Leistungselektronikeinheit 16 sind an zwei Platinen 66 befestigt. In einer anderen Ausgestaltung können die Leistungselemente der Leistungselektronikeinheit 16 auch an einer einzelnen Platine 66 befestigt sein. Ein Wärmetransportelement 36 (Fig. 5) verbindet den Deckkörper 24 thermisch mit der Leistungselektronikeinheit 16. Das Wärmetransportelement 36 ist von einem Kühlkörper aus Aluminium gebildet. Andruckelemente 68, die von Stahlwinkeln gebildet sind drücken die Leistungselemente der Leistungselektronikeinheit 16 gegen das Wärmetransportelement 36, so dass ein hoher Wärmeübergang erreicht wird. Schrauben 52 befestigen das Wärmetransportelement 36 an dem Deckkörper 24, so dass es einen direkten Kontakt mit dem Deckkörper 24 aufweist (Fig. 6). Das Wärmetransportelement 36 weist eine Wärmetransportleistung auf, die mehr als viermal so groß ist wie eine Wärmetransportleistung umgebender Bauteile. Die Schrauben 52 weisen eine geringere Wärmetransportleistung auf als das Wärmetransportelement 36, so dass ein Großteil der Wärme über das Wärmetransportelement 36 an den Deckkörper 24 abgeführt wird. Aufgrund der Dichtungseinheit 28, die als Gummidichtung ausgeführt ist, fällt die abgeführte Abwärme hauptsächlich an dem Deckkörper 24 an, und der Hauptkörper 22 erwärmt sich gegenüber dem Deckkörper 24 nur geringfügig. Insbesondere beträgt in einem Ladezustand ein Temperaturunterschied zwischen dem Deckkörper 24 und dem Hauptkörper 22 zumindest zehn Grad Celsius. Eine Erwärmung des Hauptkörpers 22 des Elektronikgehäuses 20 bei einer maximalen Leistungsabgabe der Leistungselektronikeinheit 16 ist aufgrund der Dichtungseinheit 28 und einer Kühlung des Deckkörpers 24 auf fünfzig Grad Celsius beschränkt, so dass der Hauptkörper 22 des Elektronikgehäuses 20 und somit außenliegende Teile der Akkuladevorrichtung 10 von einem Benutzer ohne Verletzungsgefahr kurzzeitig berührt werden können.

Die Kühleinheit 30 der Akkuladevorrichtung 10 umfasst einen Lüfter 32, der dazu vorgesehen ist, einen Luftstrom zur Kühlung des Elektronikgehäuses 20 zu erzeugen. Der Lüfter 32 ist zwischen dem Deckkörper 24 und dem Akkuaufnahmeraum 14 in einem weiteren, von dem Akkuaufnahmeraum 14 durch ein Wandungselement 62 des Akkuaufnahmegehäuses 12 teilweise getrennten Raum angeordnet. Der Lüfter 32 kühlt das Elektronikgehäuse 20 in einem Betriebszustand von außen, wobei der Luftstrom auf den Deckkörper 24 gerichtet ist. Das Wandungselement 62 weist schlitzförmige Durchlassöffnungen 64 auf, durch die von dem Lüfter 32 Luft aus einem Außenbereich angesaugt wird. Die Akkuladevorrichtung 10 weist ein Luftführungsmittel 34 auf, das Luft an einem in den zumindest einen Akkuaufnahmeraum 14 eingesetzten Akku vorbei führt. Das Luftführungsmittel 34 ist als Seitenkanal, der von einem zurückgesetzten Teilbereich des Akkuaufnahmegehäuses 12 gebildet ist, ausgebildet. Der Luftstrom wird auf die Kühlrippen 26 des Deckkörpers 24 geleitet und führt dort die Wärme ab. Durch die Erwärmung der von dem Lüfter 32 angesaugten Luft wird eine erhöhte Luftabsaugleistung erreicht.

In alternativen Ausführungen der Erfindung kann der Lüfter in dem Akkuaufnahmeraum 14, in dem Elektronikaufnahmeraum 18 in Richtung auf den Akkuaufnahmeraum 14 gesehen vor der Leistungselektronikeinheit 16, in einem Bereich, der von dem Akkuaufnahmeraum 14 aus gesehen hinter der Leistungselektronikeinheit 16, entweder in dem Elektronikaufnahmeraum 18 oder in einem von dem Elektronikaufnahmeraum 18 separaten Raum, angeordnet sein.

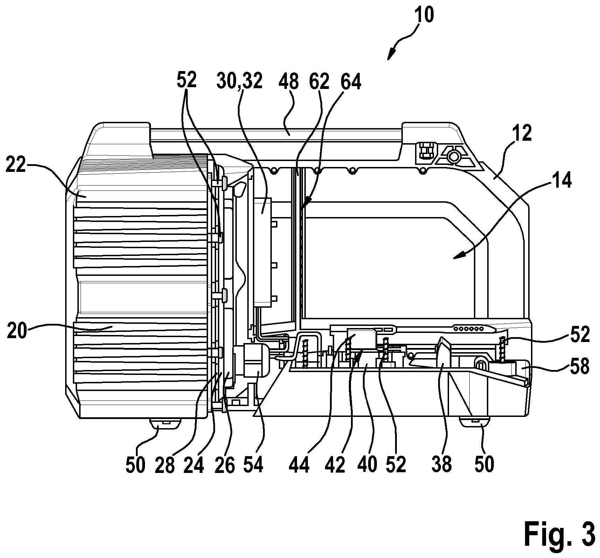

Die Akkuladevorrichtung 10 weist ein Verriegelungsmittel 38 (Fig. 3) auf, das dazu vorgesehen ist, in zumindest einem Ladezustand einen in einen Akkuaufnahmeraum 14 eingesetzten Akku zu verriegeln. Das Verriegelungsmittel 38 ist in dem Akkuaufnahmeraum 14 angeordnet und stellt einen kraftschlüssigen Kontakt mit einem in den Akkuaufnahmeraum 14 eingesetzten Akku her, so dass dieser in einer Position fixiert ist. Insbesondere kann die Akkuladevorrichtung 10 aufgenommen und bewegt werden, ohne dass ein Herausfallen des Akkus befürchtet werden muss. Das Verriegelungsmittel 38 ist mit einem Betätigungsmittel 58, welches an dem Akkuaufnahmegehäuse 12 benachbart der Öffnung des Akkuaufnahmeraums 14 angeordnet ist, mechanisch verbunden. Durch ein Herunterdrücken des Betätigungsmittels 58 wird das Verriegelungsmittel 38 in das Akkuaufnahmegehäuse 12 eingezogen, so dass der Akku entnommen werden kann.

Die Akkuladevorrichtung 10 umfasst eine in dem Akkuaufnahmeraum 14 angeordnete Akkuschnittstelle 40 (Fig. 4) zu einer elektrischen Kontaktierung eines Akkus. Drei blank ausgeführte Kontaktelemente 44 sind in einem Kontaktbereich 42 der Akkuschnittstelle 40 angeordnet. Über die Kontaktelemente 44 fließt ein Ladestrom zu einem die Kontaktelemente 44 kontaktierenden Akku. Die Akkuschnittstelle 40 weist einen Plastikgrundkörper auf, der in einer dazu vorgesehenen Aussparung des Akkuaufnahmegehäuses 12 aufgenommen ist und dort mit Schrauben 52 befestigt ist. Über ein Stromleitungselement 54 ist die Akkuschnittstelle 40 mit der Leistungselektronikeinheit 16 verbunden und wird von dieser mit Strom mit der Ladespannung versorgt. Ein Abzweig des Stromleitungselements 54 versorgt den Lüfter 32 mit Strom (Fig. 2). Die Ackuschnittstelle 40 weist Wasserablauföffnungen 46 auf, die in den Plastikgrundkörper eingebracht sind und durch die auftreffendes Wasser abgeleitet wird. Das Wasser wird durch die Wasserablauföffnungen 46 in einen Hohlraum des Akkuaufnahmegehäuses 12 geleitet, aus dem es durch Schlitze in einem Boden des Akkuaufnahmegehäuses 12 abgeleitet wird. Die Akkuladevorrichtung 10 kann somit auch bei in den Akkuaufnahmeraum 14 eintretendem Wasser, beispielsweise Regenwasser, sicher zu einer Aufladung eines zumindest teilweise wasserdichten Akkus verwendet werden. Da das Elektronikgehäuse 20 wasserdicht ausgebildet ist, ist die Leistungselektronikeinheit 16 gegenüber in den Akkuaufnahmeraum 14 eindringendem Wasser geschützt. Der Lüfter 32 ist ebenfalls gegen Beschädigungen durch Wasser geschützt. Die Akkuschnittstelle 40 weist eine Akkueinschubrichtung auf, die auf den einen Lüfter 32 zu gerichtet ist.

## Patentansprüche

1. Akkuladevorrichtung mit einem Akkuaufnahmegehäuse (12), das zumindest einen Akkuaufnahmeraum (14) zumindest teilweise begrenzt, und mit zumindest einer Leistungselektronikeinheit (16), die zumindest dazu vorgesehen ist, eine Ladespannung bereitzustellen, wobei ein von dem Akkuaufnahmegehäuse (12) getrennt ausgebildetes Elektronikgehäuse (20) dazu vorgesehen ist, die Leistungselektronikeinheit (16) zumindest wassergeschützt und staubgeschützt aufzunehmen,
**dadurch gekennzeichnet, dass** das zumindest eine Elektronikgehäuse (20) zumindest einen Deckkörper (24) mit Kühlrippen (26) und einen Hauptkörper (22) aufweist, die einen Elektronikaufnahmeraum (18) für die zumindest eine Leistungselektronikeinheit (16) vollständig umschließen, wobei das zumindest eine Elektronikgehäuse (20) zumindest ein Wärmetransportelement (36) aufweist, das den zumindest einen Deckkörper (24) thermisch mit der Leistungselektronikeinheit (16) verbindet, und wobei das zumindest eine Elektronikgehäuse (20) zumindest eine Dichtungseinheit (28) aufweist, die den zumindest einen Deckkörper (24) und den Hauptkörper (22) thermisch zumindest teilweise entkoppelt, wobei der Hauptkörper (22) und das Akkuaufnahmegehäuse (12) einen äußeren durch einen Benutzer berührbaren Teil der Akkuladevorrichtung (10) bilden.

2. Akkuladevorrichtung nach Anspruch 1, **gekennzeichnet durch** zumindest einen Lüfter (32), der dazu vorgesehen ist, einen Luftstrom zur Kühlung des Elektronikgehäuses (20) zu erzeugen.

3. Akkuladevorrichtung nach Anspruch 2, **dadurch gekennzeichnet, dass** der zumindest eine Lüfter (32) zwischen einem Deckkörper (24) und dem Akkuaufnahmeraum (14) angeordnet ist.

4. Akkuladevorrichtung nach einem der vorhergehenden Ansprüche,
**gekennzeichnet durch** zumindest ein Luftführungsmittel (34), das Luft an einem in den zumindest einen Akkuaufnahmeraum (14) eingesetzten Akku vorbei führt.

5. Akkuladevorrichtung nach einem der vorhergehenden Ansprüche,
**gekennzeichnet durch** zumindest ein Verriegelungsmittel (38), das dazu vorgesehen ist, in zumindest einem Ladezustand einen in einen Akkuaufnahmeraum (14) eingesetzten Akku zu verriegeln.

6. Akkuladevorrichtung nach einem der vorhergehenden Ansprüche,
**gekennzeichnet durch** zumindest eine Akkuschnittstelle (40) zu einer elektrischen Kontaktierung eines Akkus, die zumindest ein blank ausgeführtes Kontaktelement (44) aufweist.

7. Akkuladevorrichtung nach Anspruch 6, **dadurch gekennzeichnet, dass** die zumindest eine Akkuschnittstelle (40) Wasserablauföffnungen (46) aufweist.

8. Akkuladevorrichtung nach Anspruch 6 oder 7, **dadurch gekennzeichnet, dass** die zumindest eine Akkuschnittstelle (40) eine Akkueinschubrichtung aufweist, die auf den zumindest einen Lüfter (32) zu gerichtet ist.

9. Akkuladevorrichtung nach einem der vorhergehenden Ansprüche, **dadurch gekennzeichnet, dass** das Akkuaufnahmegehäuse (12) zumindest teilweise aus einem Kunststoffmaterial und das Elektronikgehäuse (20) zumindest teilweise aus einem Metall hergestellt ist.

10. Akkuladevorrichtung nach einem der vorhergehenden Ansprüche,
**gekennzeichnet durch** einen Handgriff (48), der auf einer Seite mit dem Akkuaufnahmegehäuse (12) und auf einer entgegengesetzten Seite mit dem Elektronikgehäuse (20) verbunden ist.

11. System aus einer Akkuladevorrichtung (10) nach einem der vorhergehenden Ansprüche und einem zumindest teilweise wasserdicht ausgebildeten Akku.

## Claims

1. Battery charging apparatus comprising a battery holding housing (12), which at least partly delimits at least one battery holding space (14), and comprising at least one power electronics unit (16), which is at least provided to supply a charging voltage, wherein an electronics housing (20) which is designed to be separate from the battery holding housing (12) is provided to hold the power electronics unit (16) in a manner at least protected from water and protected from dust, **characterized in that** the at least one electronics housing (20) has at least one covering body (24) with cooling fins (26) and has a main body (22), which covering body and main body completely surround an electronics holding space (18) for the at least one power electronics unit (16), wherein the at least one electronics housing (20) has at least one heat transport element (36) which thermally connects the at least one covering body (24) to the power electronics unit (16), and wherein the at least one electronics housing (20) has at least one sealing unit (28) which at least partly thermally decouples the at least one covering body (24) and the main body (22), wherein the main body (22) and the battery holding housing (12) form an outer portion of the battery charging apparatus (10) that can be touched by a user.

2. Battery charging apparatus according to Claim 1, **characterized by** at least one fan (32) which is provided to generate an air flow for cooling the electronics housing (20).

3. Battery charging apparatus according to Claim 2, **characterized in that** the at least one fan (32) is arranged between a covering body (24) and the battery receiving space (14).

4. Battery charging apparatus according to one of the preceding claims, **characterized by** at least one air-guiding means (34) which guides air past a battery inserted into the at least one battery holding space (14) .

5. Battery charging apparatus according to one of the preceding claims, **characterized by** at least one locking means (38), which is provided to lock a battery inserted into a battery holding space (14) in at least one charging state.

6. Battery charging apparatus according to one of the preceding claims, **characterized by** at least one battery interface (40) for electrically contacting a battery, which battery interface has at least one contact element (44) of blank design.

7. Battery charging apparatus according to Claim 6, **characterized in that** the at least one battery interface (40) has water outflow openings (46).

8. Battery charging apparatus according to Claim 6 or 7, **characterized in that** the at least one battery interface (40) has a battery insertion direction, which is directed towards the at least one fan (32).

9. Battery charging apparatus according to one of the preceding claims, **characterized in that** the battery holding housing (12) is produced at least partly from a plastics material and the electronics housing (20) is produced at least partly from a metal.

10. Battery charging apparatus according to one of the preceding claims, **characterized by** a handle (48), which is connected on one side to the battery holding housing (12) and on an opposite side to the electronics housing (20) .

11. System comprising a battery charging apparatus (10) according to one of the preceding claims and a battery which is at least partly water-tight.

## Revendications

1. Dispositif de charge de batterie comprenant un boîtier de réception de batterie (12), qui délimite au moins partiellement au moins un espace de réception de batterie (14), et comprenant au moins une unité électronique de puissance (16), qui est prévue au moins pour fournir une tension de charge, un boîtier d'électronique (20) réalisé séparément du boîtier de réception de batterie (12) étant prévu pour recevoir l'unité électronique de puissance (16) au moins de manière protégée de l'eau et protégée de la poussière,
**caractérisé en ce que** l'au moins un boîtier d'électronique (20) présente au moins un corps de recouvrement (24) comprenant des nervures de refroidissement (26) et un corps principal (22), qui entourent entièrement un espace de réception d'électronique (18) pour l'au moins une unité électronique de puissance (16), l'au moins un boîtier d'électronique (20) présentant au moins un élément de transport de chaleur (36), qui relie thermiquement l'au moins un corps de recouvrement (24) à l'unité électronique de puissance (16), et l'au moins un boîtier d'électronique (20) présentant au moins une unité d'étanchéité (28), qui découple thermiquement au moins partiellement l'au moins un corps de recouvrement (24) et le corps principal (22), le corps principal (22) et le boîtier de réception de batterie (12) formant une partie extérieure du dispositif de charge de batterie (10) pouvant être touchée par un utilisateur.

2. Dispositif de charge de batterie selon la revendication 1, **caractérisé par** au moins un ventilateur (32), qui est prévu pour produire un courant d'air pour refroidir le boîtier d'électronique (20) .

3. Dispositif de charge de batterie selon la revendication 2, **caractérisé en ce que** l'au moins un ventilateur (32) est agencé entre un corps de recouvrement (24) et l'espace de réception de batterie (14) .

4. Dispositif de charge de batterie selon l'une quelconque des revendications précédentes, **caractérisé par** au moins un moyen d'acheminement d'air (34), qui achemine de l'air devant une batterie insérée dans l'au moins un espace de réception de batterie (14).

5. Dispositif de charge de batterie selon l'une quelconque des revendications précédentes, **caractérisé par** au moins un moyen de verrouillage (38), qui est prévu pour verrouiller, dans au moins un état de charge, une batterie insérée dans un espace de réception de batterie (14).

6. Dispositif de charge de batterie selon l'une quelconque des revendications précédentes, **caractérisé par** au moins une interface de batterie (40) pour une mise en contact électrique d'une batterie, qui présente au moins un élément de contact (44) réalisé à nu.

7. Dispositif de charge de batterie selon la revendication 6, **caractérisé en ce que** l'au moins une interface de batterie (40) présente des ouvertures d'évacuation d'eau (46).

8. Dispositif de charge de batterie selon la revendication 6 ou 7, **caractérisé en ce que** l'au moins une interface de batterie (40) présente une direction d'enfilage de batterie, qui est dirigée vers l'au moins un ventilateur (32).

9. Dispositif de charge de batterie selon l'une quelconque des revendications précédentes, **caractérisé en ce que** le boîtier de réception de batterie (12) est au moins partiellement fabriqué en un matériau plastique et le boîtier d'électronique (20) est au moins partiellement fabriqué en un métal.

10. Dispositif de charge de batterie selon l'une quelconque des revendications précédentes, **caractérisé par** une poignée (48), qui est reliée d'un côté au boîtier de réception de batterie (12) et d'un côté opposé au boîtier d'électronique (20).

11. Système composé d'un dispositif de charge de batterie (10) selon l'une quelconque des revendications précédentes et d'une batterie réalisée au moins partiellement sous forme étanche à l'eau.
